# EUROPEAN PATENT APPLICATION

(11) **EP 2 190 040 A2**
(43) Date of publication of application: **26.05.2010**
(21) Application number: 09008385.8
(22) Date of filing: 26.06.2009
(51) Int. Cl.: H01L 33/48, H01L 33/54

(54) **Light-emitting diode device and method for fabricating the same**

(30) Priority: 25.11.2008 US 323094
(71) Applicant: VisEra Technologies Company Limited, Hsinchu Science Park Taiwan 300-78 (TW)
(72) Inventor: Kuo, Wu-Cheng, Taiwan 300-78 (TW); Lin, Tzu-Han, Hsinchu City 300 (TW)
(74) Representative: TER MEER - STEINMEISTER & PARTNER GbR

(57) **Abstract**

An LED device including a support structure with at least one LED die mounted thereon, a recess formed in a part of the support structure from a side of the LED die, and a lens formed over the support structure to encapsulate the LED die and the recess, thereby forming a protrusion in the support structure is disclosed.

## Description

### BACKGROUND OF THE INVENTION

### Field of the Invention

The invention relates to a light-emitting diode (LED) device and more particularly to LED devices with improved adhesion of a lens thereon.

### Description of the Related Art

Light-emitting diode (LED) devices are solid-state light sources with multiple-advantages. They are capable of reliably providing light with high brightness and thus are applied in displays, traffic lights and indicators. LED devices typically include an LED die electrically bonded on a support substrate and the LED die may have an n-contact formed on one side and a p-contact formed on the opposite side therein or have both contacts formed on the same side therein.

The LED die in an LED device typically emit light in a lambertian pattern. It is common to provide a lens over the LED die of the LED device to narrow the beam or to make a side-emission pattern. A common type of lens for a surface mounted LED is a molded plastic lens, which is bonded to a package in which the LED die is mounted.

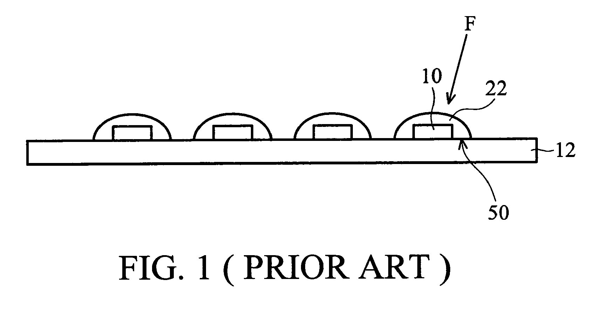

FIG. 1 is a cross section of a conventional LED device disclosed in U. S. Patent 7,344,902, issued to Basin et al. As shown in FIG. 1, the LED device has four LED die 10 mounted on a support structure 12 such as ceramic or silicon substrate with metal leads, a metal heat sink, a printed circuit board, or any other structure. A molded lens 22 is provided over each LED die 10 to cover each LED die 10.

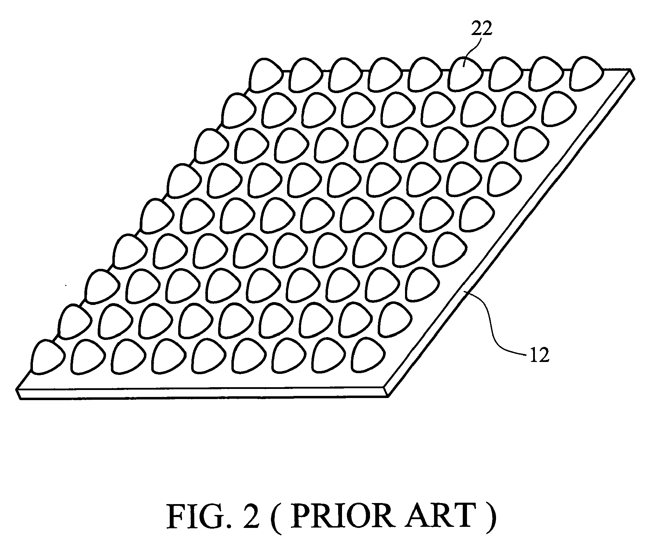

FIG. 2 is a perspective view of a conventional LED device where the support structure 12 supports an array of LED die, each having a molded lens 22. The mold used normally has a corresponding array of indentations. If the support structure 12 were a ceramic or silicon submount, each LED die 10 (with its underlying submount portion) can be separated by sawing or breaking of the submount 12 to form individual LED devices. Alternatively, the support structure 12 may be separated/diced to support subgroups of LEDs or may be used without being separated/diced.

The lens 22 not only improves the light extraction from the LED die 10 and refracts the light to create a desired emission pattern, but also encapsulates the LED die 10 to protect the die from contaminants, adds mechanical strength, and protects wire bonds.

However, since the support structure 12 shown in FIGS. 1 and 2 is provided with a substantially planar top surface, the adhesion between the lens 22 covering the LED die 10 and the support structure 12 is mainly maintained by physical forces such as van der Waals forces. Thus, because the physical bonding force for adhering the lens 22 to the underlying support structure 12 is not strong enough, the lens 22 easily peels off from the support structure 12 when an external force F is applied thereto. In addition, an interface 50 between the lens 22 and the underlying support structure 12 provides a leakage path for environmental moisture to seep in. This causes reliability problems of the LED product. Thus, poor reliably of the LED device is affected by adhesion of the lens 22 to the underlying support structure.

Therefore, there is a need for a novel LED device addressing the above problems.

### BRIEF SUMMARY OF THE INVENTION

A detailed description is given in the following embodiments with reference to the accompanying drawings. A light-emitting diode (LED) device and a method for fabricating the same are provided. An embodiment of an LED device comprises a support structure with at least one LED die mounted thereon, a recess formed in a part of the support structure from a side of the LED die, and a lens formed over the support structure to encapsulate the LED die and the recess, thereby forming a protrusion in the support structure.

An embodiment of a method for fabricating an LED device comprises providing a support structure with at least one LED die mounted thereon. A recess is formed in a part of the support structure from a side of the LED die. A lens is formed over the support structure to encapsulate the LED die and the recess, thereby forming a protrusion in the support structure.

### BRIEF DESCRIPTION OF THE DRAWINGS

The invention can be more fully understood by reading the subsequent detailed description and examples with references made to the accompanying drawings, wherein:

FIG. 1 is a cross section of a conventional LED device;

FIG. 2 is a perspective view of a conventional LED device;

FIGS. 3-5 are cross sections showing a method for fabricating LED devices according to an embodiment the invention;

FIG. 6 is a cross section of a method for fabricating LED devices according to another embodiment of the invention;

FIGS. 7 and 8 are enlarged cross sections showing an LED device according to various embodiments of the invention, respectively; and

FIGS. 9-11 are enlarged top views showing an LED device according to various embodiments of the invention.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

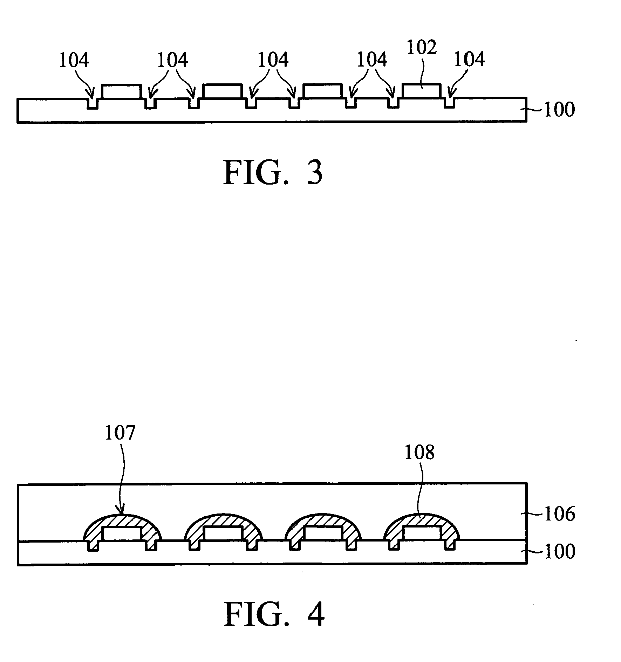

FIGS. 3-5 are cross sections showing an exemplary method for fabricating LED devices. As shown in FIG. 3, a cross section showing four LED die 102 mounted on a support structure 100 is illustrated. The support structure 100 can be, for example, a submount (e.g., ceramic or silicon substrate with metal pads), a metal heat sink, a printed circuit board, or any other support structure. In this embodiment, the support structure 100 is a silicon submount with metal pads (not shown). As shown in FIG. 3, a plurality of recesses 104 are formed in the support structure 100, respectively adjacent to an opposite side of each LED die 102. The recesses 104 can be formed by methods such as an etching, laser cutting, or mechanical cutting depending on the material of the support structure 100 and are spaced from the LED die 102 by the support structure 100.

In FIG. 4, a mold 106 having a plurality of indentations 107 corresponding to the desired shape of a lens over each LED die 102 is provided. The mold 106 can be made of materials such as metal, plastic or polymer and can be opaque or light-transmissive. A very thin non-stick film (not shown) having the general shape of the mold 106, can be optionally placed over the mold 106 to prevent molding lens material to stick to the mold 106. The mold indentions 107 are then filled with a heat-curable or light-curable liquid lens material 108. The liquid lens material 108 can be any suitable optically transparent material such as silicone, an epoxy, or a hybrid silicone/epoxy. A hybrid may be used to achieve a matching coefficient of thermal expansion (CTE). Silicone and epoxy have a sufficiently high index of refraction (greater than 1.4) to greatly improve the light extraction from an AIInGaN or AlInGaP LED as well as act as a lens.

In this embodiment, the support structure 100 and the mold 106 are pressed against each other so that each LED die 102 is inserted into the liquid lens material 108 and the lens material 108 is under compression. At this time, the liquid lens material 108 fills the recesses 104 formed in the support structure 100. The mold 106 is then heated to about 150 °C or other suitable temperature, or subjected to a suitable light source such as a ultraviolet (UV) light for a period of time to harden the lens material 108.

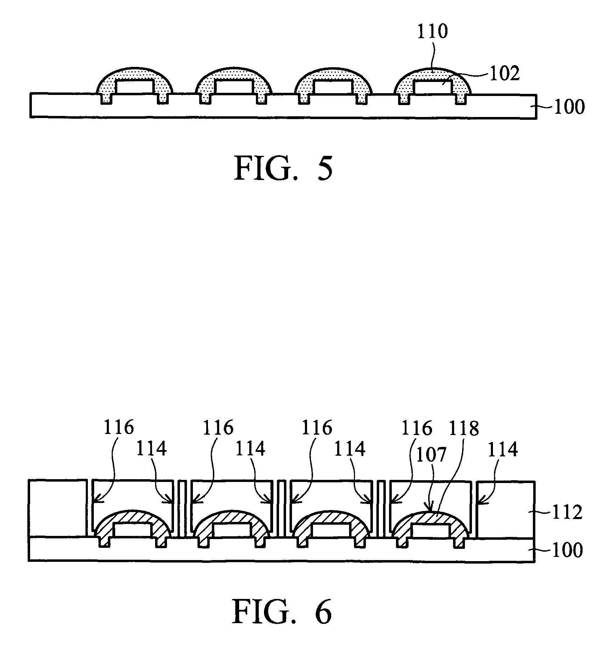

After the support structure 100 is separated from the mold 106 (not shown), an LED device with a lens 110 over each LED die 102 is formed as illustrated in FIG. 5. The lens 110 can be any size or shape, and is not limited to that illustrated in FIG. 5. As shown in FIG. 5, the lenses 110 are all formed with protrusions formed into the support structure 100, thereby improving adhesion between the lens 110 and the support structure 100.

The LED device shown in FIG. 5 can be formed with a perspective view as that shown in FIG. 2, wherein the support structure 100 supports an array of LED dies, each having a lens 110 covered thereon. In this case, the mold (not shown) used would have a corresponding array of indentations. If the support structure 100 is a ceramic or silicon submount, each LED device (with its underlying submount portion) can be separated by sawing or breaking of the submount 100 to form individual LED device. Alternatively, the support structure 100 may be separated/diced to support subgroups of the LED device or may be used without being separated/diced. The lenses 110 are not only improves the light extraction from the LED die and refracts the light to create a desired emission pattern, but also encapsulates the LED die to protect the die from contaminants, adds mechanical strength, and protects conductive bonding therein.

FIG. 6 shows another exemplary method for fabricating the LED device illustrated in FIG. 5. In this embodiment, a gel-dispensing method is used to form the lenses 110 by providing a modified mold 112 having a plurality of indentations 107 corresponding to the desired shape of a lens over each LED die 102. In each of the indentations 107, a plurality of through holes 114 and 116 are provided. The mold 112 can be provided over the structure shown in FIG. 3. At this time, a pair of holes 114 and 116 is provided from a side for each of the the indentations 107, respectively, having a substantially L shape or reversed-L shape. One of the through hole pairs 114 and 116 functions as an inlet channel to fill the gel-like lens materials into the indentations 107 and the other through hole functions as a suction channel connected to the vacuum surroundings (not shown). Thus, the lens materials can be filled into the indentations 107 formed in the mold 112 and then hardened by the methods as that discussed in FIG. 4, thereby forming the lens 110 covering each LED die 102 in the embodiment.

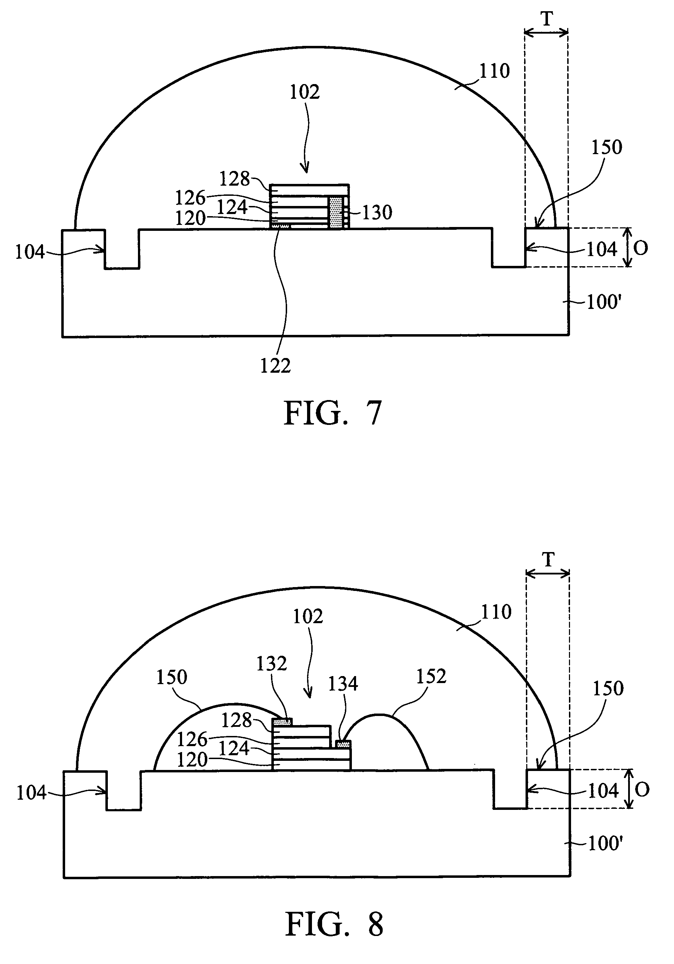

FIG. 7 is an enlarged cross section showing an exemplary LED device having a single flip-chip LED die 102 formed on a submount 100' of any suitable material, such as a ceramic or silicon. In one embodiment, the submount 100' may be function as the support structure 100 illustrated in FIGs. 3-6 and may be separated from the LED device, as illustrated in FIG. 5, by sawing. The LED die 102 in FIG. 7 has a bottom p-contact layer 120, a p-metal contact 122, p-type layers 124, a light emitting active layer 126, n-type layers 128, and an n-metal contact 130 contacting the n-type layers 128. Metal pads (not shown) on the submount 100' are directly metal-bonded to contacts 122 and 130, respectively. The lens 110, formed using the technique of FIGS. 3-6, encapsulates the LED die 102 and has a plurality of protrusions filling the recesses 104 in the submount 100'.

The LED die 102 in FIG. 7 may also be a non-flip-chip die, with a wire 152 connecting the n-layer and the p-layer with a metal pad (not shown) on the submount' 100. The lens 110 may encapsulate the wire. FIG. 8 is an enlarged cross section showing another exemplary LED device having a non flip-chip LED die 102 having a top n-metal contact 132 connected to a metal lead by the wire 150 and an exposed p-metal contact 134 connected to another metal pad by a wire 152. The LED die 102 is mounted on the submount 100'. As that illustrated in FIG. 8, the lens 110 encapsulates the LED die 102 and has a plurality of protrusions filling the recesses 104 formed in the support structure 100.

As shown in FIGS. 7-8, since the lens 110 is now formed with protrusions penetrating into the support structure 100 thereunder, adhesion between the lens 110 and the underlying support structure 100 is thus improved. Additionally, an undesired moisture leakage path formed at an interface 150 between the lens 110 and the underlying support structure 110 is blocked by the protrusions, thus improve the reliability of the LED device.

In one embodiment, the recesses 104 are typically formed with a depth O of about 100∼300 µm from the top surface the submount 100' or the support structure 100 and with a distance T of about 500∼1000 µm from an outer edge of the submount 100' or the support structure 100.

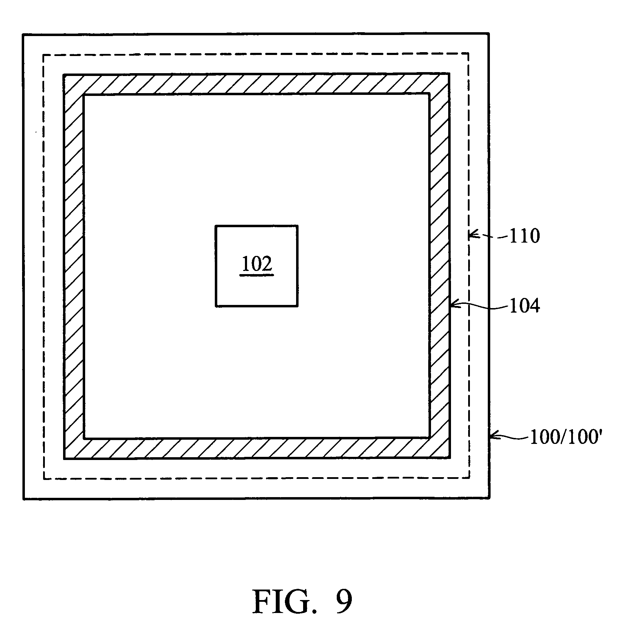

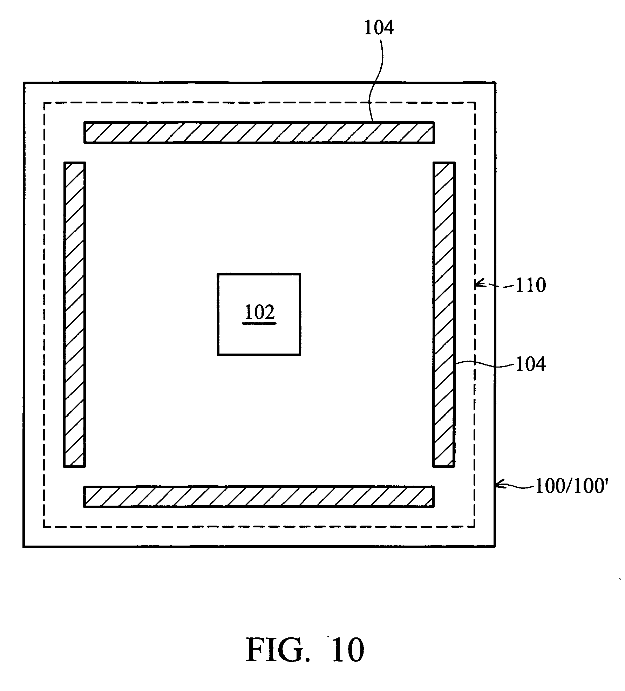

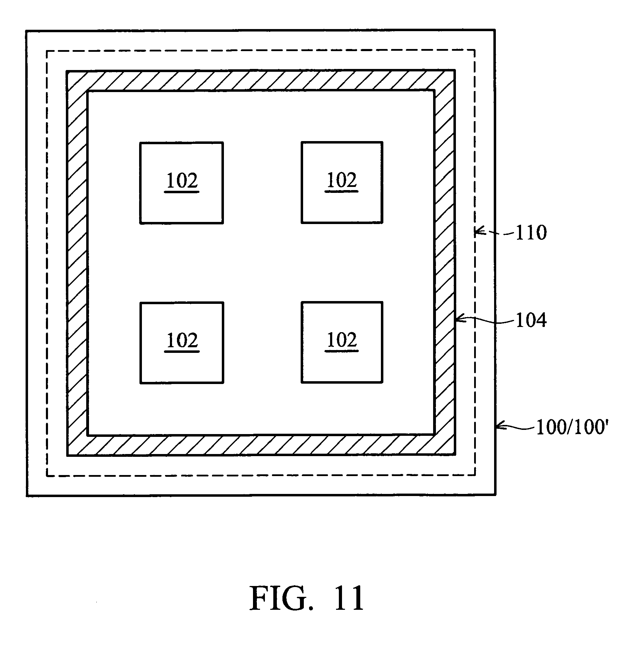

FIGS. 9-11 are schematic top views showing various embodiments of an LED device. As shown in FIG. 9, a plurality of regions is defined over the submount 100' or the support structure 100. In the embodiment illustrated in FIG. 9, the recess 104 is formed as a continuous trench in the support structure 100. The continuous trench illustrated in FIG. 9 surrounds all sides of the LED die 102, thereby improving adhesion of the lens 110 and the support substrate 100/submount 100'. The recess 104 can be formed as several non-continuous trenches 104 formed in the submount 100' or the support structure 100. The non-continuous trenches 104 respectively surround each side of the LED die 102, thereby substantially surrounding the LED die 102 and improving adhesion of the lens 110 and the support substrate 100/submount 100', as shown in FIG. 10. In FIG. 11, another embodiment showing an LED device having an array of LED die surrounded by the recess 104 is illustrated. In this embodiment, the recess 104 is formed as a continuous trench surrounding a plurality LED die 102 and is not limited thereto, the recess 104 can be also formed as several non-continuous trenches 104 as that illustrated in FIG. 10. The LED die 102 illustrated in FIG. 11 is electrically mounted to the support substrate 100/submount 100' by the methods illustrated in FIGs. 7 and 8.

While the invention has been described by way of example and in terms of the preferred embodiments, it is to be understood that the invention is not limited to the disclosed embodiments. To the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A light-emitting diode (LED) device, comprising:
- a support structure with at least one LED die mounted thereon;
- a recess formed in a part of the support structure from a side of the LED die; and
- a lens formed over the support structure, encapsulating the LED die and the recess, having a protrusion formed in the support structure.

2. The LED device as claimed in claim 1, wherein the recess is formed as a continuous trench from a top view, and the continuous trench surrounds the LED die.

3. The LED device as claimed in claim 1, wherein the recess is formed as a plurality of non-continuous trenches from a top view, and the non-continuous trenches respectively surround the LED die from a side thereof.

4. A method for fabricating a light-emitting diode (LED) device, comprising:
- providing a support structure with at least one LED die mounted thereon;
- forming a recess in a part of the support structure from a side of the LED die; and
- forming a lens over the support structure, encapsulating the LED die and the recess, having a protrusion formed in the recess.

5. The method as claimed in claim 4, wherein forming the lens over the support structure comprises:
- providing a mold with an indention therein over the support substrate, wherein the indention corresponds to the lens shape;
- filling the indention of the mold with a lens material;
- pressing the mold with the indention filled by the lens material toward the support structure; and
- hardening the lens material and removing the mold, thereby forming the lens over the support structure to encapsulate the LED die and fill the recess, thereby forming a protrusion into the support structure.

6. The method as claim in claim 4, wherein the recess is formed by an etching, laser cutting, or mechanical cutting process.

7. The method as claim in claim 4, wherein the mold comprises metal, plastic or polymer materials.

8. The method as claimed in claim 5, wherein the recess is formed as a continuous trench from a top view and the continuous trench surrounds the LED die.

9. The method as claimed in claim 4, wherein the recess is formed as a plurality of non-continuous trenches from a top view and each of non-continuous trenches substantially surrounds the LED die from a side thereof.

10. The method as claimed in claim 5, wherein the mold is formed with a pair of through holes, and the lens materials is filled into the indention of the mold by gel dispersion.
